# EUROPÄISCHE PATENTANMELDUNG

(11) **EP 4 517 818 A1**
(43) Veröffentlichungstag der Anmeldung: **05.03.2025**
(21) Anmeldenummer: 24195548.3
(22) Anmeldetag: 21.08.2024
(51) Int. Cl.: H01L 23/49, H01L 23/34, H01L 23/367, H01L 23/42, H01L 23/492, H05K 1/02, H05K 3/34, H01L 23/498

(54) **LEISTUNGSMODUL UND VERFAHREN ZUR HERSTELLUNG EINES LEISTUNGSMODULS**

(30) Priorität: 30.08.2023 DE 102023208297
(71) Anmelder: Volkswagen Aktiengesellschaft, 38440 Wolfsburg (DE)
(72) Erfinder: Kube, Adrian, 91097 Oberreichenbach (DE)

(57) **Zusammenfassung**

Die Erfindung betrifft ein Leistungsmodul (1), umfassend mindestens eine Leiterplatte (6) mit mindestens einem Leistungshalbleiter (7), ein Gehäuse (2), ein isolierendes Füllmaterial (5) und eine isolierende Folie (9), wobei in die isolierende Folie (9) mindestens ein lötbarer Kontakt (10) eingebettet ist, der jeweils seitlich aus der isolierenden Folie (9) herausragt und mit der Leiterplatte (6) verlötet ist, sowie ein Verfahren zur Herstellung eines Leistungsmoduls (1).

## Beschreibung

Die Erfindung betrifft ein Leistungsmodul und ein Verfahren zur Herstellung eines Leistungsmoduls.

Ein Leistungsmodul umfasst mindestens eine Leiterplatte mit mindestens einem Leistungshalbleiter, ein Gehäuse und ein isolierendes Füllmaterial. Das isolierende Füllmaterial wird auch als Gap-Filler bezeichnet. Gap-Filler sind weiche, elastische relativ dicke Thermal Pads mit wärmeleitenden Eigenschaften und gleichen durch ihre Materialstärke und Elastizität Höhendifferenzen zwischen Bauteilen aus. Um die Spannungsfestigkeit zu erhöhen, ist auch bereits eine Kombination aus Gap-Filler und einer dünnen isolierenden Folie bekannt. Eine solche isolierende Folie ist beispielsweise unter der Marke Kapton-MT-Folie bekannt und beispielsweise 25 µm dick.

Die Leistungshalbleiter in derartigen Leistungsmodulen erzeugen relativ große Verlustleistungen im Watt-Bereich. Ein weiteres Problem ist, dass diese häufig mit hohen Frequenzen geschaltet werden. Dies führt zu EMV-Problemen, sodass die Gehäuse zur Abschirmung elektrisch leitend sind. Beispielsweise sind Gehäuse aus Aluminium-Druckguss bekannt. Da auf den Leiterplatten Spannungen im Hochvoltbereich anliegen können (z.B. 400 V), müssen die spannungsführenden Teile einen Mindest-Abstand zum Gehäuse aufweisen. Dies ist beispielsweise in einer IEC-Norm geregelt. Dabei werden Luftstrecken angegeben.

Bei den Gap-Fillern besteht das Problem, dass für diese Widerstandswerte angegeben werden, aber keine Gewährleistung für die Spannungsfestigkeit gegeben wird, da Fehlstellen und Einschlüsse im Material nicht ausgeschlossen werden können. Dies kann beispielsweise teilweise dadurch kompensiert werden, dass die Dicke des Gap-Fillers dicker als in der Norm angegeben gewählt wird. Zusätzlich kann man eine zuvor beschriebene isolierende Folie verwenden. Allerdings erweist sich die Handhabung derartiger Folien als schwierig. Diese müssen beispielsweise mittels Acryl- oder Polysiloxankleber mit dem Gap-Filler und dem Gehäuse verklebt werden. Dieser Klebeprozess mit den sehr dünnen Folien ist prozesstechnisch schwierig und lässt sich nur schwer automatisieren. Ein weiteres Problem ist, dass die Oberfläche des Gehäuses rau ist, was den Klebeprozess weiter erschwert, sodass das Gehäuse entsprechend bearbeitet werden müsste.

Aus der DE 10 2007 057 533 B4 ist eine Leiterplatte mit Kühlkörper bekannt, wobei die Leiterplatte zur besseren thermischen Anbindung Vias aufweist, also Löcher bzw. Durchkontaktierungen von der Ober- zur Unterseite der Leiterplatte.

Der Erfindung liegt das technische Problem zugrunde, ein Leistungsmodul zu schaffen, das vereinfacht herstellbar ist, sowie ein entsprechendes Herstellungsverfahren zur Verfügung zu stellen.

Die Lösung des technischen Problems ergibt sich durch ein Leistungsmodul mit den Merkmalen des Anspruchs 1 sowie ein Verfahren mit den Merkmalen des Anspruchs 9. Weitere vorteilhafte Ausgestaltungen der Erfindung ergeben sich aus den Unteransprüchen.

Das Leistungsmodul umfasst mindestens eine Leiterplatte mit mindestens einem Leistungshalbleiter, ein Gehäuse, ein isolierendes Füllmaterial und eine isolierende Folie, wobei in die isolierende Folie mindestens ein lötbarer Kontakt eingebettet ist, der jeweils seitlich aus der isolierenden Folie herausragt und mit der Leiterplatte verlötet ist. Hierdurch muss die Folie nicht mehr verklebt werden, wobei der Lötvorgang vorzugsweise in den übrigen Lötprozess der Leiterplatte integriert werden kann. Die Verlötung der Kontakte dient also primär der mechanischen Anbindung. Ein weiterer Vorteil ist, dass die lötbaren Kontakte auch Wärme von der Leiterplatte abführen. Das Gehäuse ist vorzugsweise elektrisch leitend und weiter vorzugsweise aus Metall. Das isolierende Füllmaterial (Gap-Filler) weist vorzugsweise einen elektrischen Durchgangswiderstand von größer/gleich 10⁶ Ωm auf. Dabei sei angemerkt, dass Gap-Filler hier begrifflich auch Gap-Pads miteinschließen soll. Die isolierende Folie hat vorzugsweise eine Durchschlagsspannung von größer 5 kV.

In einer Ausführungsform ist die isolierende Folie als Leiterplattenverbinder ausgebildet. Derartige Leiterplattenverbinder dienen eigentlich dazu, zwei Leiterplatten zu verbinden und sind SMT (Surface Mount Technology) tauglich. Vorliegend wird nun ausgenutzt, dass diese Leiterplattenverbinder eine isolierende Schicht mit eingebetteten Kontakten bereits haben, sodass auf diese als kostengünstiges Standardelement zurückgegriffen werden kann. Solche Leiterplattenverbinder werden beispielsweise von der Firma SUMIDA unter der Produktbezeichnung PANTA angeboten.

In einer weiteren Ausführungsform weist das Leistungsmodul mindestens einen Kühlkörper auf, was die Wärmeabfuhr verbessert.

Dabei kann in einer Ausführungsform der Kühlkörper unterhalb der Leiterplatte angeordnet sein.

In einer alternativen Ausführungsform ist der mindestens eine Kühlkörper auf dem mindestens einen Leistungshalbleiter angeordnet. Auch sind Ausführungen möglich, wo beide Varianten kombiniert werden.

In einer weiteren Ausführungsform weist die Leiterplatte Vias auf, um die thermische Anbindung zu verbessern.

In einer weiteren Ausführungsform ist die isolierende Folie zwischen dem Kühlkörper und dem isolierenden Füllmaterial angeordnet, wobei die isolierende Folie den Kühlkörper und das isolierende Füllmaterial vollständig überdeckt, sodass Spannungsdurchschläge zuverlässig vermieden werden. Ein weiterer Vorteil ist, dass die Folie nicht direkt mit dem Gehäuse in Kontakt kommt, sodass dieses nicht extra nachbearbeitet werden muss.

In einer weiteren Ausführungsform weist das Gehäuse an einem Boden oder einem Deckel einen in das Innere des Gehäuses ragenden Vorsprung auf. Hierdurch existiert eine definierte Auflagefläche, wobei zusätzlich der Abstand der Leiterplatte, der nicht von der isolierenden Folie überdeckt ist, zum Gehäuse vergrößert wird.

Die Leistungshalbleiter sind vorzugsweise die Leistungstransistoren eines Puls-Wechselrichters.

Das Verfahren zur Herstellung eines Leistungsmoduls, wobei das Leistungsmodul mindestens eine Leiterplatte mit mindestens einem Leistungshalbleiter, ein Gehäuse, ein isolierendes Füllmaterial und eine isolierende Folie aufweist, wobei in die isolierende Folie mindestens ein lötbarer Kontakt eingebettet ist, der jeweils seitlich aus der isolierenden Folie herausragt, umfasst den Verfahrensschritt, dass der mindestens eine Kontakt mit der Leiterplatte verlötet wird.

Hinsichtlich der weiteren Ausgestaltung wird vollinhaltlich auf die vorausgegangenen Ausführungen Bezug genommen.

Die Erfindung wird nachfolgend anhand bevorzugter Ausführungsbeispiele näher erläutert. Die Figuren zeigen:
- Fig. 1: eine Teildarstellung eines Leistungsmoduls in einer ersten Ausführungsform,
- Fig. 2: eine Teildarstellung eines Leistungsmoduls in einer zweiten Ausführungsform und
- Fig. 3: eine perspektivische Darstellung eines Leiterplattenverbinders (Stand der Technik).

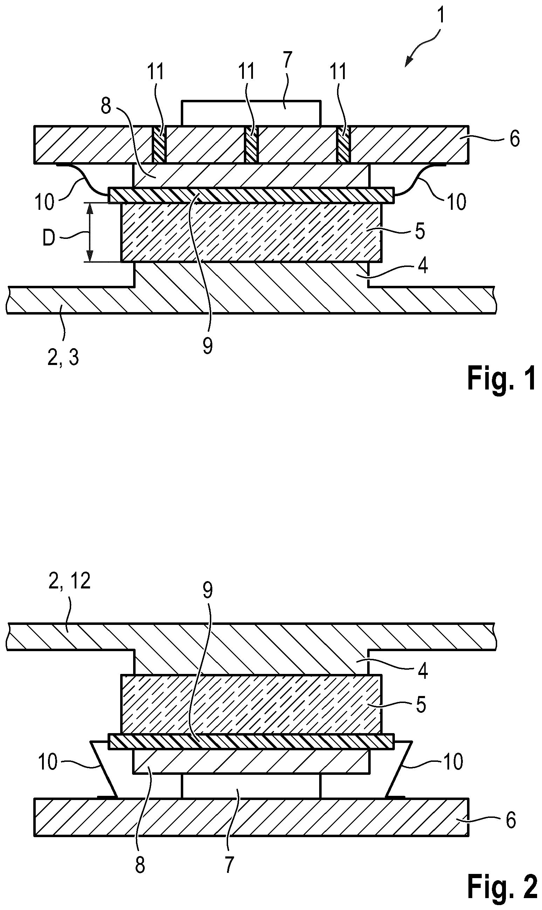

In der Fig. 1 ist eine Teildarstellung eines Leistungsmoduls 1 dargestellt, wobei das Leistungsmodul 1 ein Gehäuse 2 mit einem Boden 3 aufweist. Seitenwände und Deckel sind nicht dargestellt. Weiter weist das Gehäuse einen Vorsprung 4 auf, der in das Innere des Gehäuses 2 ragt. Auf dem Vorsprung 4 ist ein isolierendes Füllmaterial 5, ein sogenannter Gap-Filler bzw. Gap-Pad angeordnet. Das isolierende Füllmaterial 5 ragt dabei etwas über den Vorsprung 4 hinaus, kann mit diesem aber auch genau abschließen. Durch die Elastizität des isolierenden Füllmaterials 5 gleicht dieses mögliche Unebenheiten des Vorsprungs 4 aus. Die Dicke D des isolierenden Füllmaterials 5 ist dabei etwas größer als der geforderte Luftabstand gemäß IEC-Norm. Weiter weist das Leistungsmodul 1 eine Leiterplatte 6 mit mindestens einem Leistungshalbleiter 7 auf, wobei an der Unterseite der Leiterplatte 6 ein Kühlkörper 8 angeordnet ist. Weiter ist zwischen dem Kühlkörper 8 und dem isolierenden Füllmaterial 5 eine isolierende Folie 9 mit mindestens einem eingebetteten lötbaren Kontakt 10, der jeweils seitlich aus der isolierenden Folie 9 herausragt und mit der Leiterplatte 6 verlötet ist. Die Folie 9 überdeckt dabei den Kühlkörper 8 und das isolierende Füllmaterial 5 vollständig. Weiter sind Vias 11 dargestellt, um Wärme besser von der Oberseite der Leiterplatte 6 an die Unterseite abzuführen.

Zur Herstellung des Leistungsmoduls 1 kann dann in einem Lötprozess die Leiterplatte 6 mit dem Leistungshalbleiter 7, dem Kühlkörper 8 und der Folie 9 mit den Kontakten 10 verbunden werden. Der Kühlkörper 8 kann aber auch durch ein anderes Verfahren zwar mit der Leiterplatte 6 verbunden werden (z.B. mittels einer Klebe- oder Sinterverbindung). Das isolierende Füllmaterial 5 kann dann auf den Vorsprung 5 positioniert werden, wobei dann anschließend die Baugruppe, bestehend aus Leiterplatte 6, Leistungshalbleiter 7, Kühlkörper 8 und Folie 9, auf dem isolierenden Füllmaterial 5 positioniert wird- Die Verbindung zwischen Folie 9 und Füllmaterial 5 kann dabei eine Klebeverbindung sein, wobei hierzu das isolierende Füllmaterial auch mit einer selbstklebenden Oberseite ausgebildet sein kann.

In der Fig. 2 ist eine alternative Ausführungsform eines Leistungsmoduls 1 dargestellt, wobei gleiche Elemente wie in Fig. 1 mit gleichen Bezugszeichen versehen sind. Im Gegensatz zu Fig. 1 erfolgt die Befestigung an einem Deckel 12 des Gehäuses 2. Ein weiterer Unterschied ist, dass der Kühlkörper 8 auf dem mindestens einen Leistungshalbleiter 7 angeordnet ist. Wieder können dann Leiterplatte 6, Leistungshalbleiter 7, Kühlkörper 8 und isolierende Folie 9 in einem Lötprozess zu einer Baugruppe vorgefertigt werden, die dann auf das isolierende Füllmaterial 5 aufgesetzt wird, wobei das Füllmaterial 5 zuvor auf dem Vorsprung 4 positioniert wurde. Anschließend kann dann der Deckel 11 auf das restliche Gehäuse 2 aufgesetzt werden. Das Gehäuse 2 ist vorzugsweise ein Aluminium-Gehäuse.

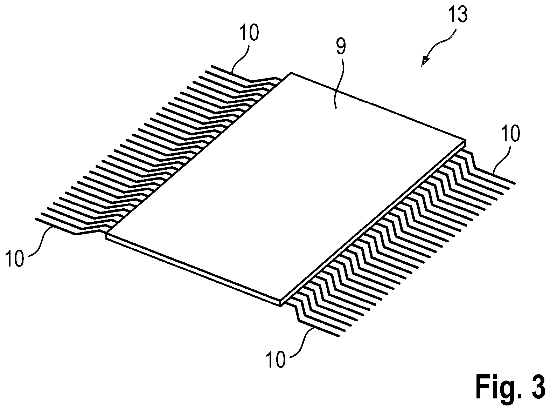

In der Fig. 3 ist perspektivisch ein Leiterplattenverbinder 12 dargestellt. Dieser weist eine Vielzahl von Kontakten 10 auf, die in einer Isolierschicht eingebettet sind. Ein solcher Leiterplattenverbinder 13 kann beispielsweise mittels eines Stanzgitters für die Kontakte 10 hergestellt werden, wobei mittig von oben und unten jeweils eine isolierende Folie abgerollt und verpresst wird. Ein solcher Leiterplattenverbinder 13 kann nun als isolierende Folie 9 mit eingebetteten, verlötbaren Kontakten 10 für das Leistungsmodul verwendet werden.

### Bezugszeichenliste

- 1: Leistungsmodul
- 2: Gehäuse
- 3: Boden
- 4: Vorsprung
- 5: Füllmaterial
- 6: Leiterplatte
- 7: Leistungshalbleiter
- 8: Kühlkörper
- 9: Folie
- 10: Kontakt
- 11: Vias
- 12: Deckel
- 13: Leiterplattenverbinder

## Patentansprüche

1. Leistungsmodul (1), umfassend mindestens eine Leiterplatte (6) mit mindestens einem Leistungshalbleiter (7), ein Gehäuse (2), ein isolierendes Füllmaterial (5) und eine isolierende Folie (9),
**dadurch gekennzeichnet, dass**
in die isolierende Folie (9) mindestens ein lötbarer Kontakt (10) eingebettet ist, der jeweils seitlich aus der isolierenden Folie (9) herausragt und mit der Leiterplatte (6) verlötet ist.

2. Leistungsmodul nach Anspruch 1, **dadurch gekennzeichnet, dass** die isolierende Folie (9) als Leiterplattenverbinder (13) ausgebildet ist.

3. Leistungsmodul nach Anspruch 1 oder 2, **dadurch gekennzeichnet, dass** das Leistungsmodul (1) mindestens einen Kühlkörper (8) aufweist.

4. Leistungsmodul nach Anspruch 3, **dadurch gekennzeichnet, dass** der Kühlkörper (8) unterhalb der Leiterplatte (6) angeordnet ist.

5. Leistungsmodul nach Anspruch 3, **dadurch gekennzeichnet, dass** der Kühlkörper (8) auf dem mindestens einen Leistungshalbleiter (7) angeordnet ist.

6. Leistungsmodul nach einem der Ansprüche 3 bis 5, **dadurch gekennzeichnet, dass** die Leiterplatte (6) Vias (11) aufweist.

7. Leistungsmodul nach einem der Ansprüche 3 bis 6, **dadurch gekennzeichnet, dass** die isolierende Folie (9) zwischen dem Kühlkörper (8) und dem isolierenden Füllmaterial (5) angeordnet ist, wobei die isolierende Folie den Kühlkörper (8) und das isolierende Füllmaterial (5) vollständig überdeckt.

8. Leistungsmodul nach einem der vorangegangenen Ansprüche, **dadurch gekennzeichnet, dass** das Gehäuse (2) an einem Boden (3) oder einem Deckel (12) einen in das Innere des Gehäuses (2) ragenden Vorsprung (4) aufweist.

9. Verfahren zur Herstellung eines Leistungsmoduls (1), wobei das Leistungsmodul (1) mindestens eine Leiterplatte (6) mit mindestens einem Leistungshalbleiter (7), ein Gehäuse (2) und ein isolierendes Füllmaterial (5) aufweist,
**dadurch gekennzeichnet, dass**
in eine isolierende Folie (9) mindestens ein lötbarer Kontakt (10) eingebettet ist, der jeweils seitlich aus der isolierenden Folie (9) hervorragt, wobei der mindestens eine Kontakt (10) mit der Leiterplatte (6) verlötet wird.

10. Verfahren nach Anspruch 9, **dadurch gekennzeichnet, dass** die isolierende Folie (9) als Leiterplattenverbinder (13) mit einer Vielzahl von Kontakten (10) ausgebildet ist, wobei mindestens mehrere Kontakte (10) mit der Leiterplatte (6) verlötet werden.
